# EUROPEAN PATENT APPLICATION

(11) **EP 4 601 324 A1**
(43) Date of publication of application: **13.08.2025**
(21) Application number: 24157061.3
(22) Date of filing: 12.02.2024
(51) Int. Cl.: H04R 3/12, H04R 27/00

(54) **AUDIO REPRODUCTION SYSTEM AND METHOD**

(71) Applicant: Harman Becker Automotive Systems GmbH, 76307 Karlsbad (DE)
(72) Inventor: BARTOLOME CASTRO, Raul, 81927 München (DE)
(74) Representative: Westphal, Mussgnug & Partner, Patentanwälte mbB

(57) **Abstract**

An audio reproduction system includes a serial bus configured to transmit audio data and control data using serial data communication, and to transmit low electric power; a zone computer connected to the serial bus and configured to provide audio data and control data to the serial bus; a low-power supply connected to the serial bus to supply the low electric power to the serial bus, the low electric power having a maximum value below a threshold; and a high-power supply configured to supply high electric power, the high electric power having a maximum value above the threshold. The system further includes a low-power active loudspeaker arrangement connected to the serial bus and configured to receive the audio data, control data and low electric power over the serial bus, the low-power active loudspeaker arrangement comprising a first bus interface, a low-power loudspeaker and a low-power amplifier, the low-power amplifier being supplied with the low electric power and driving the low-power loudspeaker; and a high-power active loudspeaker arrangement connected to the serial bus and the second power supply, and configured to receive audio data and control data over the serial bus and to receive high electric power from the second power supply, the high-power active loudspeaker arrangement comprising a second bus interface, a high-power loudspeaker and a high-power amplifier, the high-power amplifier being supplied with the high electric power separately from the serial bus and driving the high-power loudspeaker.

## Description

### BACKGROUND

### 1. Technical Field

The disclosure relates to an audio reproduction system and method (herein generally referred to as a "system").

### 2. Related Art

Designers of modern audio (reproduction) systems in an automotive environment face weight, space, and cost constraints when connecting audio sources to a variety of loudspeakers. Common architectures for automotive audio applications include, at a minimum, a head unit, an intelligent multi-channel amplifier, and a plurality of loudspeakers. For example, an entry-level premium audio system may have 14 audio channels and 14 or more loudspeakers, while a top-of-the-line audio system may have more than 40 independent audio channels with at least 40 loudspeakers. In order to connect so many separate components that are far apart from each other, a lot of insulated copper wire is required, which causes high weight, high demand for space, high labor, and consequently high cost. It is desired to reduce the amount of wire required to connect a given number of loudspeakers to an audio source in an automotive audio system.

### SUMMARY

An audio reproduction system includes a serial bus configured to transmit audio data and control data using serial data communication, and to transmit low electric power; a zone computer connected to the serial bus and configured to provide audio data and control data to the serial bus; a low-power supply connected to the serial bus to supply the low electric power to the serial bus, the low electric power having a maximum value below a threshold; and a high-power supply configured to supply high electric power, the high electric power having a maximum value above the threshold. The system further includes a low-power active loudspeaker arrangement connected to the serial bus and configured to receive the audio data, control data, and low electric power over the serial bus. The low-power active loudspeaker arrangement comprises a first bus interface, a low-power loudspeaker and a low-power amplifier. The low-power amplifier is supplied with the low electric power and drives the low-power loudspeaker. The system further includes a high-power active loudspeaker arrangement connected to the serial bus and the second power supply, and configured to receive audio data and control data over the serial bus and to receive high electric power from the second power supply. The high-power active loudspeaker arrangement comprises a second bus interface, a high-power loudspeaker, and a high-power amplifier. The high-power amplifier the high-power amplifier being supplied with the high electric power separately from the serial bus and driving the high-power loudspeaker.

An audio reproduction method includes generating audio data and control data to be supplied to a serial bus; providing low electric power to the serial bus, the low electric power having a maximum value below a threshold; transmitting the low electric power and, using serial data communication, the audio data and control data over the serial bus; and supplying high electric power, the high electric power having a maximum value above the threshold. The method further includes receiving the audio data, control data, and low electric power over the serial bus, and reproducing the received audio data using a low-power loudspeaker and a low-power amplifier, the low-power amplifier being supplied with the low electric power and driving the low-power loudspeaker; and receiving the audio data and control data over the serial bus and the high electric power over a separate line, and reproducing the received audio data using a high-power loudspeaker and a high-power amplifier, the high-power amplifier being supplied with the high electric power separately from the serial bus and driving the high-power loudspeaker.

Other systems, methods, features, and advantages will be, or will become, apparent to one with skill in the art upon examination of the following detailed description and appended figures. It is intended that all such additional systems, methods, features, and advantages be included within this description, be within the scope of the invention, and be protected by the following claims.

### BRIEF DESCRIPTION OF THE DRAWINGS

The system may be better understood with reference to the following drawings and description. The components in the figures are not necessarily to scale, emphasis instead being placed upon illustrating the principles of the invention. Moreover, in the figures, like referenced numerals designate corresponding parts throughout the different views.
FIG 1 is a schematic diagram illustrating a common car audio reproduction system.
FIG 2 is a schematic diagram illustrating an exemplary car audio reproduction system with reduced wiring harness.
FIG 3 is a block diagram illustrating another exemplary car audio reproduction system with reduced wiring harness, which includes a zone computer, a high-power arrangement, and a low-power arrangement.
FIG 4 is a block diagram illustrating an exemplary zone computer that may be used in the system of FIG 3.
FIG 5 is a block diagram illustrating an exemplary high-power arrangement that may be used in the car audio reproduction system shown in FIG 3.
FIG 6 is a block diagram illustrating an exemplary low-power arrangement that may be used in the car audio reproduction system shown in FIG 3.
FIG 7 is a schematic diagram illustrating another exemplary high-power arrangement with a loudspeaker and an integrated circuit attached thereto, the high-power arrangement may be used in the car audio reproduction system shown in FIG 3.
FIG 8 is a block diagram illustrating an exemplary class D amplifier that has a digital audio input and may be used in the integrated circuits shown in FIGs 5-7.
FIG 9 is a flowchart illustrating an exemplary audio reproduction method that allows for a reduced wiring harness.

### DETAILED DESCRIPTION

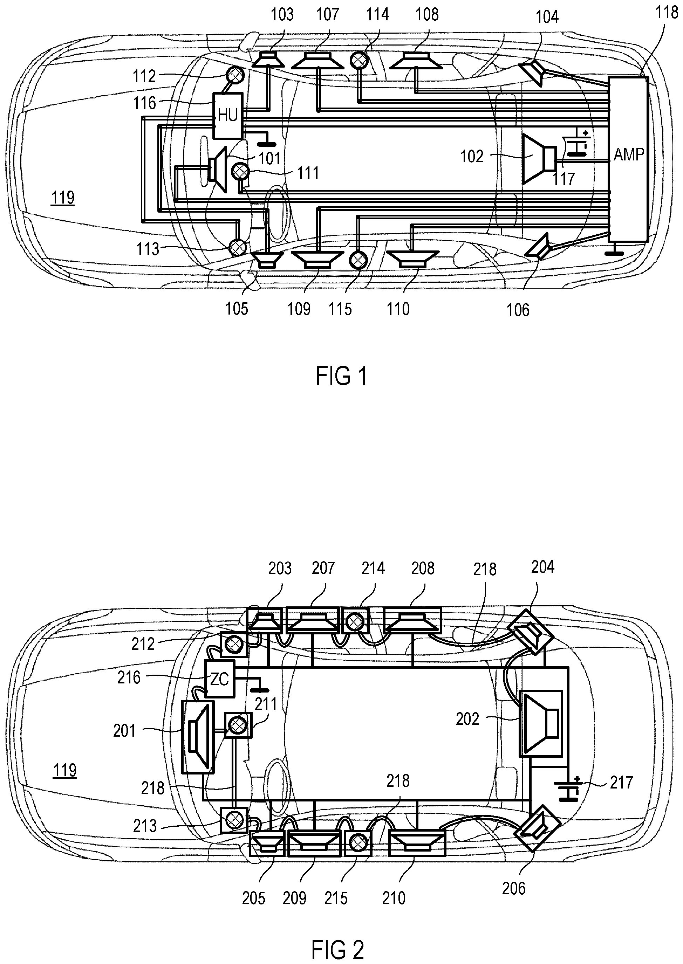

FIG. 1 illustrates a common audio reproduction system including 15 loudspeakers 101-115 (hereinafter referred to as speakers), a head unit (HU) 116, a power supply such as a battery 117, and an 11-channel smart audio amplifier (AMP) 118. All of these components 101-118 are installed in a vehicle, such as a car 119. One of the speakers 101-115 is a center speaker 101, which is mounted in the center of a dashboard of the vehicle 119. A subwoofer 102 is mounted on a rear shelf of the vehicle 119. Four low-mid-range speakers 103-106 are positioned at four corners of a cabin of the car 119. Speaker 103 is located at the right front corner, speaker 104 is located at the right rear corner, speaker 105 is located at the left front corner, and speaker 106 is located at the left rear corner. Four woofers 107-110 are mounted in four side doors of the car 119. Woofer 107 is located in the right front door, woofer 108 is located in the right rear door, woofer 109 is located in the left front door, and woofer 110 is located in the left rear door. Three high-frequency speakers, tweeters 111-113, are mounted in the center, right, and left positions of the dashboard, respectively. Additionally, two tweeters 114 and 115 are mounted near the B pillars in the right and left front doors, respectively. The battery 117 and the amplifier 118 are located in a trunk of the car 119.

The audio signal transmission wiring for components 101-116 and 118 follows a star topology. The head unit 116 and amplifier 118 together form a hub that is connected to each of the speakers 101-115 via separate two-wire lines. Specifically, speakers 103, 105, 112, and 113 are connected to the head unit 116, and all other speakers 101, 102, 104, 106-111, 114, and 115 are connected to the amplifier 118. The head unit 116 and the amplifier 118 are connected to each other to transmit audio signals to be reproduced from the head unit 116 to the amplifier 118. Both are powered by the battery 117 via a single-wire line constituting one power path, the other power path being provided by the chassis of the vehicle 119. The figures show the electrical two-wire lines as double lines.

The head unit 116 may include a voltage regulator, a microcontroller (MCU), a digital signal processor (DSP), an audio source, an audio power amplifier, a plurality of audio and power line filters, a communications transceiver, and other electronic components. The power line filter monitors the power supply line and provides overvoltage protection, short circuit protection, noise suppression, and other electrical protection. The voltage regulator provides a constant voltage lower than the battery voltage, to power electronic circuits and modules. The term "sound source" refers to any hardware or software that generates or receives audio signals. This may include digital music as data stored in a memory or streamed wirelessly from external sources. The digital signal processor may convert stereo audio signals from the audio source to a multichannel audio format and apply additional audio effects, such as surround effects and equalization. The power amplifier, possibly in conjunction with the audio filters, may implement multiple independent audio channels of equal or different power. The communication transceiver controls the data exchange between the head unit 116 and the amplifier 118 through a bus connection using common bus communication protocols such as Ethernet Audio Video Bridging (AVB) and Automotive Audio Bus (A2B). The microcontroller interacts with an engine control unit (ECU) of the car 119.

The common audio system architecture used in automotive applications, such as the architecture used in the system of FIG 1, has several drawbacks. These include a complex wiring harness, excessive weight, long time-to-market, and poor component matching. The wiring harness is extensive due to the star topology. Regardless of the location of the amplifier, two wires must run from the amplifier or head unit to each speaker. The weight of the wiring harness increases proportionally with the number of speakers due to the amount of copper and insulation required. This is a critical consideration for an original equipment manufacturer (OEM), especially in the context of electric vehicles, where lightweighting is a top priority. The amplifier, along with the head unit, follows a classic architecture and its development costs are high. Amplifier suppliers aim to standardize the amplifier design, but OEMs often have specific requirements that require a partial or complete redesign of the amplifier. The time-to-market for car audio applications is long due to the need for a complete or partial redesign of the amplifier. For example, proper system design requires matching the power requirement of the speaker to the power output of the amplifier. The suitability of a fully custom amplifier may vary depending on the application. It may work well for one application but be oversized for another.

The audio reproduction system shown in FIG 2 utilizes active speaker arrangements with corresponding positions and acoustic behaviors as shown in and described in connection with FIG 1. However, unlike the passive speakers in the system of FIG 1, the speaker arrangements (also referred to herein as smart speakers) are active. This means that each speaker arrangement includes at least some dedicated signal processing such as bus communication, amplification, and filtering. The audio reproduction system shown in FIG 2 includes 15 speaker arrangements 201-215, a zone computer (ZC) 216, and a main power supply such as a battery 217. All of the components 201-217 are installed in a vehicle, such as the car 119. One of the speaker arrangements 201-215 is a center speaker arrangement 201 mounted in the center of the dashboard of the car 119. A very-low-frequency arrangement, subwoofer arrangement 202, is mounted on the rear shelf of the vehicle 119. Four low-mid-range speaker arrangements 203-206 are positioned at the four corners of the car cabin of the vehicle 119. Speaker 203 is located at the right front corner, speaker arrangement 204 is located at the right rear corner, speaker arrangement 205 is located at the left front corner, and speaker arrangement 206 is located at the left rear corner. Four low-frequency arrangements, woofer arrangements 207-210, are mounted in four side doors of the car 119. Woofer arrangement 207 is located in the right front door, woofer arrangement 208 is located in the right rear door, woofer arrangement 209 is located in the left front door, and woofer arrangement 210 is located in the left rear door. Three high-frequency speaker arrangements, tweeter arrangements 211-213, are mounted in the center, right, and left positions of the dashboard, respectively. In addition, two tweeter arrangements 214 and 215 are mounted near the B pillars in the right and left front doors, respectively. The battery 217 is located in the trunk of the car 119.

The audio signal transmission wiring connects components 201-216 in series via a serial bus, such as a two-wire serial bus 218. In the example shown, each component is connected to its one or two adjacent components in the series via two-wire lines. The serial bus 218 transmits audio and control data from the zone computer 216 to active low-power speaker arrangements and active high-power speaker arrangements, and possibly vice versa. The active low-power speaker arrangements (also referred to herein as "low-power speaker arrangements") and active high-power speaker arrangements (also referred to herein as "high-power speaker arrangements") are specific types of smart loudspeakers and are described in detail below. The serial bus 218 not only transmits data and control signals, but also electric power up to a certain threshold. This power is used to power one or more low-power speaker arrangements connected to the serial bus 218. Components 101-115 can be arranged in any order along the serial bus to minimize the wire length. The bus is capable of carrying both data and power simultaneously and may have varying structures and protocols. For example, the known Automotive Audio Bus (A2B) provides an applicable structure and protocol.

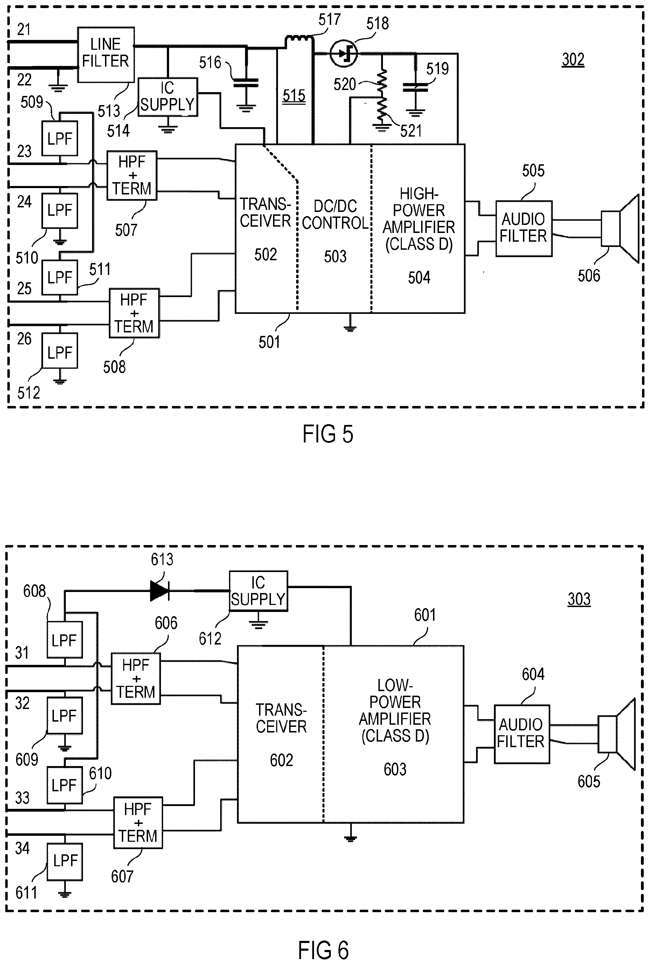

In the system illustrated in FIG 2, the five tweeter arrangements 211-215 constitute the low-power active speaker arrangements powered via the serial bus 218. The total electric power of all of the low power arrangements supplied over the serial bus 218 is below the threshold. This is to prevent overloading of the serial bus 218. The low-power active speaker arrangement comprises a low-power speaker, a low-power amplifier, a serial bus interface, and possibly other circuitry or devices as described below in connection with FIG 5. One or more high-power active speaker arrangements, such as high-power speaker arrangements 201-210, are connected to the serial bus 218 to receive audio and control data. The required high electric power is received from the battery 217 via a single wire power line constituting one power path. The other power path is provided by the chassis of the vehicle 119. The maximum value of the high electric power is above the threshold. The high-power speaker arrangements 201-210 include a serial bus interface, a high-power speaker and a high-power amplifier. The high-power amplifier is supplied with the high electric power and drives the high-power speaker and possibly other circuitry or devices as described below in connection with FIG 6.

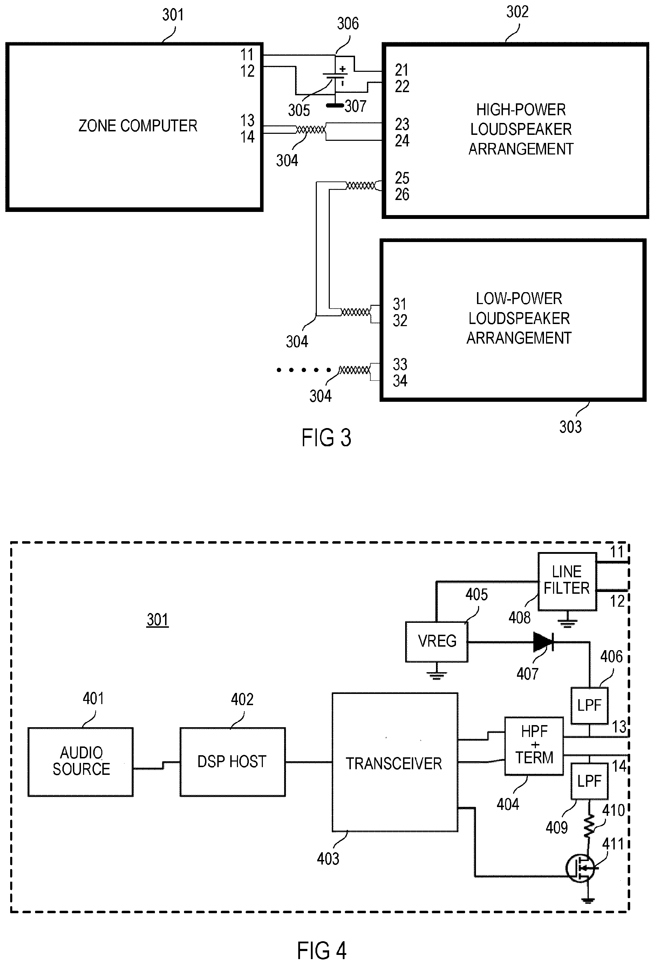

The audio reproduction system shown in FIG 3 includes a zone computer 301, a high-power loudspeaker arrangement 302, a low-power arrangement 303, and potentially additional high-power and/or low-power speaker arrangements (not shown in FIG 3). The components 301-303, and potentially others, are connected in series via a twisted pair, two-wire serial bus 304. The serial bus 304 is used to transmit digital audio data, digital control data, and low power. The high-power loudspeaker array 302 is connected to the zone computer 301 at one end and to the low-power array 303 at the other end via the serial bus 304. The high-power loudspeaker arrangement 302 and the zone computer 301 are further connected to a battery 305 (or other power source) via a high-power supply bus. The high-power supply bus includes a single wire 306 as one power path, while the other power path is constituted by a car chassis 307 (car not shown in FIG 3). The zone computer 301, high-power loudspeaker arrangement 302, and low-power arrangement 303 are described in detail below in connection with FIG 4 (zone computer 301), FIG 5 (high-power loudspeaker arrangement 302) and FIG 6 (low-power arrangement 303). Reference numbers 11-14, 21-26, 31-34 designate corresponding electrical terminals throughout FIGs 3-6.

Referring to FIG 4, the zone computer 301 may include an audio source 401 and a digital signal processor (DSP) 402 acting as a host computer. The digital signal processor 402 is connected between the audio source 401 and a transceiver 403. The transceiver 403 is connected to terminals 13 and 14 via a high-pass filter (HPF) 404 with integrated line termination (TERM). Terminals 13 and 14 are external connectors for the two wires of the serial bus 304. Terminal 13 is internally connected to a positive voltage output of a voltage regulator 405 through a low-pass filter (LPF) 406 and a diode 407. The voltage regulator 405 acts as a low-power source and receives power from the battery 305, which acts as a high-power source, through a line filter 408, terminals 11 and 12, and the high-power supply bus constituted by wire 306 and car chassis 307. Terminal 14 is internally connected to a negative voltage output (ground) of the voltage regulator 405 through a series circuit including a low-pass filter 409, a resistor 410, and a transistor 411. The transistor 411 functions as a controllable switch controlled by the transceiver 403. The voltage regulator 405 supplies power to the audio source 401, the digital signal processor (DSP) 402, the transceiver 403, and possibly other components such as the high-pass filter 404 and the low-pass filters 406 and 409. The transceiver 403, together with the high-pass filter 404, the low-pass filters 406 and 409, and the diode 407, forms a bus interface capable of transmitting and possibly receiving data and power over a two-wire line by transmitting power as direct current (DC) and data as superimposed alternating current (AC). The voltage regulator 405 may supply the or an additional supply voltage to other components (not shown).

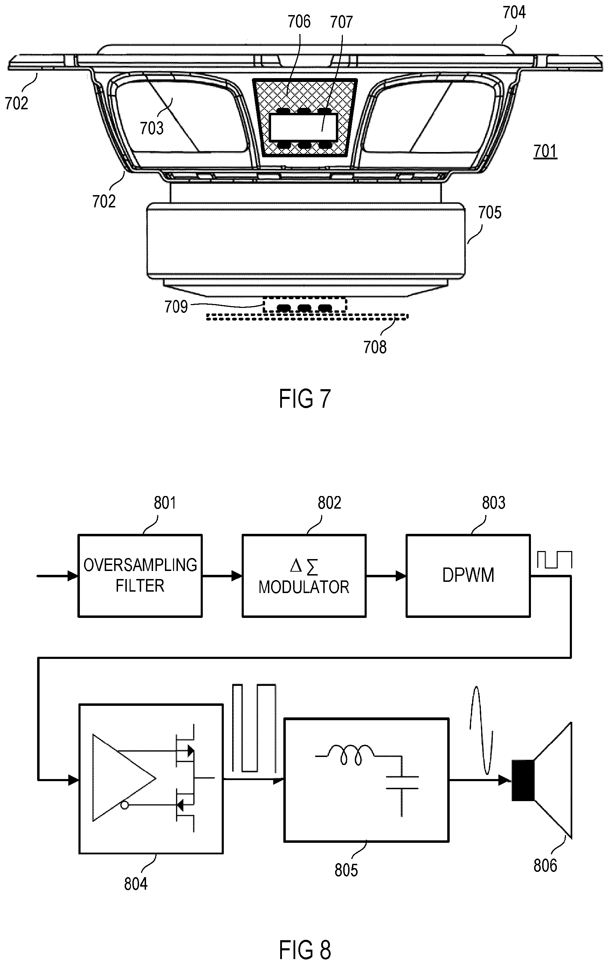

The high-power speaker arrangement 302 shown in FIG 5 includes an integrated circuit 501 that serves as a transceiver 502, a controller 503 for a DC/DC converter, and a high-power audio amplifier 504, potentially among other functions (not shown). The high-power audio amplifier 504 is implemented, for example, in a Class D configuration as shown in FIG 8. The high-power speaker 506, such as a midrange speaker, woofer, or subwoofer, is connected to the amplifier 504 through an audio filter 505 having a low-pass characteristic. The transceiver 502 receives audio and control data from the zone computer 301 via a portion of the serial bus 304, terminals 23 and 24, and a high-pass filter 507 with integrated line termination. The transceiver 502, together with the high-pass filters 507 and 508, forms a bus interface capable of transmitting and receiving data over a two-wire line. It then forwards the received data to other components, such as the low-power speaker arrangement 303, through a high-pass filter 508 with integrated line termination, terminals 25 and 26, and another portion of the serial bus 304. The transceiver 502, together with the high-pass filters 507 and 508, forms a bus interface capable of transmitting and receiving data over a two-wire line. Low-pass filters 509-512 are used to bypass the transceiver 502 for DC between terminals 23 and 25, and between terminals 24 and 26, to transmit DC to the subsequent low-power arrangement 303. Terminals 23 and 25 are connected by a series circuit of low-pass filters 509 and 511, and terminals 24 and 26 are connected via ground by a series circuit of low-pass filters 510 and 512.

The high-power speaker arrangement 302 is externally connected to the battery 305 for a separate power supply via terminals 21 and 22 and the high-power supply bus 306, 307. Internally, the terminals 21 and 22 are connected to an IC voltage supply circuit 514 via a line filter 513 that acts as a power conditioner to suppress noise and interferences, provide surge protection, etc. The IC voltage supply circuit 514 supplies power to the low voltage driven portions of the IC 501, such as the transceiver 502 and the DC/DC controller 503. The DC/DC controller 503 controls a DC/DC upconverter 515 that powers higher voltage portions of the IC 501, including the high-power amplifier 504. The DC/DC converter 515 includes a first capacitor 516 serving as an input voltage buffer connected in parallel to an output of the line filter 513, and a series circuit of an inductor 517, a rectifier 518 and a second capacitor 519. The series circuit of inductor 517, rectifier 518 and second capacitor 519 is connected in parallel with capacitor 516. The second capacitor 519 serves as an output voltage buffer. The DC/DC controller 503 has an input for measuring the voltage across the first capacitor 516. Another input of the DC/DC controller 503 measures the voltage across the second capacitor 519 using a voltage divider, which is a series circuit of two resistors 520 and 521 with a tap therebetween. In addition, the DC/DC controller 503 has a switching output that is connected to a node between the inductor 517 and the rectifier 518. The voltage across the second capacitor 519 (output voltage) exceeds the voltage across the first capacitor 516 (input voltage). This higher output voltage is supplied to the high-power amplifier 504, allowing it to produce greater output power. The IC supply circuit 514 and the input and output voltages of the DC/DC converter 515 are referenced to ground as an internal reference of the high-power speaker arrangement 302. Filters 505 and 507-513 are analog.

The low-power speaker arrangement 303, as depicted in FIG 6, includes an integrated circuit 601 that performs the functions of a transceiver 602 and a low-power audio amplifier 603 that may be configured in a Class D configuration with low-power switching transistors. The amplifier 603 is connected to a low-power speaker 605, such as a tweeter, through an audio filter 604 with a low-pass characteristic. The transceiver 602 receives data from the zone computer 301 via portions of the serial bus 304, the high-power speaker arrangement 302, terminals 31 and 32, and a high-pass filter 606 with integrated line termination. It then passes the received data to other components (not shown) via a high-pass filter 607 with integrated line termination, terminals 25 and 26, and another portion of the serial bus 304. Low-pass filters 608-611 are used to bypass the transceiver 602 for DC between terminals 31 and 33 and between terminals 32 and 34. The series circuit of low-pass filters 608 and 610 connects terminals 31 and 33, while the series circuit of low-pass filters 609 and 611 connects terminals 32 and 34 (e.g., via ground). To power the low-power speaker arrangement 303, an IC voltage supply circuit 612 is connected through a diode 613 to a node between the low-pass filters 608 and 610. The IC supply circuit 612 supplies power to the IC 601 and possibly other circuits in the low-power speaker arrangement 303. The filters 604 and 606-611 are analog filters. The transceiver 602, together with the high-pass filters 606 and 607, the low-pass filters 608-611, and the diode 613, forms a bus interface capable of transmitting and receiving data and power over a two-wire line by transmitting power as direct current (DC) and data as superimposed alternating current (AC).

FIG 7 shows an exemplary high-power speaker arrangement including a woofer 701 (or a midrange speaker or subwoofer). The woofer 701 includes a speaker chassis 702, a diaphragm 703 movably attached to the speaker chassis 702 by a suspension 704 and a spider (not shown), and a diaphragm drive system of which only the outer surface of a magnet 705 is visible. An electric circuit board 706 is mounted on the speaker chassis 702 and carries an IC 707, such as the IC 501 shown in and described above in connection with FIG 5, and possibly other devices. One surface of the IC 707 faces the circuit board 706, while the opposite surface is in thermal contact with the speaker chassis 702. As a result, the IC 707 is sandwiched between the speaker chassis 702 and the circuit board 706. Alternatively or additionally, the IC 707 may be attached to the speaker chassis 702 using adhesive, solder, or screws. The speaker chassis 702 is made of metal, which makes it thermally conductive and allows heat from the IC 707 to be dissipated, so that the speaker chassis 702 provides a preexisting large heat dissipation area. In addition, the movement of the diaphragm 703 during operation of the speaker (woofer 701) provides a form of ventilation for an additional cooling effect. As a result, the space required for the arrangement shown in Figure 7 is only slightly larger than that required for the speaker alone. Alternatively, as shown by the dotted lines in FIG 7, an electrical circuit board 708 carrying an IC 709 may be attached to the magnet 705 in a manner similar to how the circuit board 706 is attached to the speaker chassis 702.

Integrating a power amplifier into an IC and cooling it through the speaker chassis is particularly effective when the amplifier has low heat dissipation. An example of such an amplifier is a class D amplifier, as schematically shown in FIG 8. A class D amplifier, also known as a switching amplifier, is an electronic amplifier in which the amplifying devices, such as transistors, act as electronic switches rather than linear gain devices as in other amplifiers. The device operates by rapidly switching between supply rails using pulse-width modulation, pulse-density modulation, or related techniques to produce a pulse train output. A simple low-pass filter can be used to attenuate the high-frequency content to provide analog output current and voltage. The transistors dissipate little power because they are always either fully on or fully off, resulting in efficiencies that can exceed 90%. Class D amplifiers generate a train of rectangular pulses of fixed amplitude but varying width and separation to represent the amplitude variations of the analog audio input signal.

In some implementations, such as the exemplary class D amplifier shown in FIG 8, the pulses are synchronized with an incoming digital audio signal, thereby eliminating the need to convert the digital signal to analog. Therefore, the digital signals provided by the transceiver can easily be used to control the subsequent amplifier. In the class D amplifier shown in FIG 8, the digital audio signal from the transceiver is first fed to an oversampling filter 801 followed by a delta-sigma modulator 802. This process increases the sample rate of the digital audio signal, resulting in an oversampled signal. The oversampled digital audio signal is fed into a digital pulse-width modulator (DPWM) 803, which produces a series of rectangular pulses of a constant amplitude but varying width and separation based on the oversampled digital audio signal. The output of the modulator 803 is then used to alternately turn on and off the output transistors of a subsequent power stage 804. The amplitude provided by the power stage 804 is greater than that provided by the digital pulse-width modulator 803, thus increasing the output power. The use of class D amplifiers allows for minimal power dissipation due to the transistors being fully on or off at a high sample rate. In addition, a simple low-pass filter (e.g., an inductor combined with a capacitor) can be used to provide a path for the low frequencies of the audio signal while leaving the high-frequency pulses behind. The result is a pure analog signal with high amplitude delivered to a speaker. Both high-power speaker arrangements 201-210 and low-power speaker arrangements 211-215 can benefit from this technology and its efficiency. The power stage 804 can utilize various switching structures, such as full bridge and half bridge (as shown).

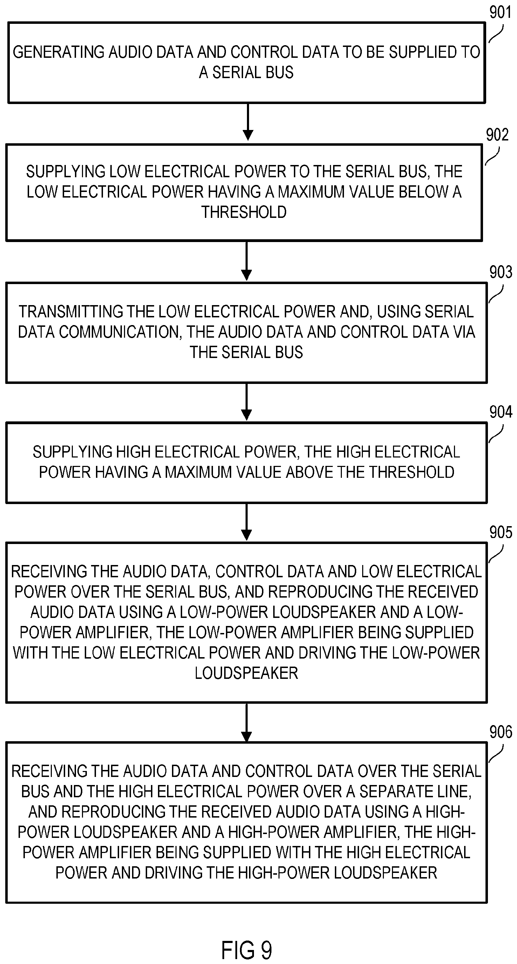

An exemplary audio reproduction method as depicted in FIG 9 includes the steps of: generating audio data and control data to be supplied to a serial bus (901), supplying low electric power to the serial bus, the low electric power having a maximum value below a threshold (902), transmitting the low electric power and, using serial data communication, the audio data and control data over the serial bus (903), and supplying high electric power, the high electric power having a maximum value above the threshold (904). The method further includes receiving the audio data, control data and low electric power over the serial bus, and reproducing the received audio data using a low-power loudspeaker and a low-power amplifier, the low-power amplifier being supplied with the low electric power and driving the low-power loudspeaker (905) and receiving the audio data and control data over the serial bus and the high electric power over a separate line, and reproducing the received audio data using a high-power loudspeaker and a high-power amplifier, the high-power amplifier being supplied with the high electric power and driving the high-power loudspeaker (906). It is understood that the order of certain steps may vary depending on the specific application.

In this method, data and power are transmitted over a two-wire data and power bus as the serial bus. The method may further include reproducing the received audio data using at least one additional low-power loudspeaker and at least one additional low-power amplifier, the at least one additional low-power amplifier being supplied with the low electric power and driving the at least one additional low-power loudspeaker, the sum of the powers of the low-power amplifier and the at least one additional low-power active amplifier being below the threshold.

The systems described offer several advantages, including simplified wiring harness design, reduced weight, faster time-to-market for components and the overall system, perfectly matched amplifiers and transducers, future-proof electrical/electronic (E/E) architecture, and lower development costs. For example, the wiring harness is simplified and requires an extremely short total wiring distance. As a result, the weight and space requirements of the wiring harness are significantly lower than those of the commonly used star topology.

In addition, the overall audio architecture can be made lighter. This weight reduction is achieved by using a bus topology that carries both data and power over fewer wires, eliminating the multi-channel amplifier, and eliminating audio amplification in the head unit. In most applications, a conventional heat sink is not required as the speaker acts as the heat sink, in other applications an additional small heat sink may be added as needed.

This E/E audio architecture, including the smart speakers, available in both high-power and low-power arrangements, has a significantly faster time-to-market compared to other solutions. The OEM can select the set of smart speakers that best fits its brand expectations and vehicle type, and then perform audio tuning.

The matching of amplifier and speaker is ideal when using smart speakers, resulting in a lower cost of matching compared to traditional methods. The architecture is consistent with the macro trend of centralized computing and can be seamlessly integrated into the E/E domain architecture of centralized architectures. Smart speakers do not require any software development, as all computing is done in the central zone computer.

The systems may include additional or different logic and may be implemented in many different ways. The zone computer and the transceivers may be implemented as a microprocessor, microcontroller, application specific integrated circuit (ASIC), discrete logic, or a combination of other types of circuits or logic. Similarly, memories may be DRAM, SRAM, Flash, or other types of memory. Parameters (e.g., conditions and thresholds) and other data structures may be separately stored and managed, may be incorporated into a single memory or database, or may be logically and physically organized in many different ways. Programs and instruction sets may be parts of a single program, separate programs, or distributed across several memories and processors.

The description of embodiments has been presented for purposes of illustration and description. Suitable modifications and variations to the embodiments may be performed in light of the above description or may be acquired from practicing the methods. For example, unless otherwise noted, one or more of the described methods may be performed by a suitable device and/or combination of devices. The described methods and associated actions may also be performed in various orders in addition to the order described in this application, in parallel, and/or simultaneously. The described systems are exemplary in nature, and may include additional elements and/or omit elements.

As used in this application, an element or step recited in the singular and proceeded with the word "a" or "an" should be understood as not excluding plural of said elements or steps, unless such exclusion is stated. Furthermore, references to "one embodiment" or "one example" of the present disclosure are not intended to be interpreted as excluding the existence of additional embodiments that also incorporate the recited features. The terms "first," "second," and "third," etc. are used merely as labels, and are not intended to impose numerical requirements or a particular positional order on their objects.

While various embodiments of the invention have been described, it will be apparent to those of ordinary skilled in the art that many more embodiments and implementations are possible within the scope of the invention. In particular, the skilled person will recognize the interchangeability of various features from different embodiments. Although these techniques and systems have been disclosed in the context of certain embodiments and examples, it will be understood that these techniques and systems may be extended beyond the specifically disclosed embodiments to other embodiments and/or uses and obvious modifications thereof.

## Claims

1. An audio reproduction system comprising:
a serial bus configured to transmit audio data and control data using serial data communication, and to transmit low electric power;
a zone computer connected to the serial bus and configured to provide audio data and control data to the serial bus;
a low-power supply connected to the serial bus to supply the low electric power to the serial bus, the low electric power having a maximum value below a threshold;
a high-power supply configured to supply high electric power, the high electric power having a maximum value above the threshold;
a low-power active loudspeaker arrangement connected to the serial bus and configured to receive the audio data, control data, and low electric power over the serial bus, the low-power active loudspeaker arrangement comprising a first bus interface, a low-power loudspeaker and a low-power amplifier, the low-power amplifier being supplied with the low electric power and driving the low-power loudspeaker; and
a high-power active loudspeaker arrangement connected to the serial bus and the high-power supply, and configured to receive audio data and control data over the serial bus and to receive high electric power from the high-power supply, the high-power active loudspeaker arrangement comprising a second bus interface, a high-power loudspeaker and a high-power amplifier, the high-power amplifier being supplied with the high electric power separately from the serial bus and driving the high-power loudspeaker.

2. The system of claim 1, wherein the serial bus is a two-wire data and power bus, in which data and power are transmitted over the two wires of the serial bus.

3. The system of claim 1 or 2, wherein at least one of the low-power amplifier and the high-power amplifier is a class-D amplifier.

4. The system of any of claims 1-3, wherein the low-power active loudspeaker arrangement and the high-power active loudspeaker arrangement further comprise at least one of a bus interface, a power conditioner and a multiplicity of first analog filters.

5. The system of any of claims 1-4, wherein the high-power active loudspeaker arrangement comprises a DC/DC converter that converts an input supply voltage to a higher output supply voltage, the input supply voltage being provided by the high-power supply and the output supply voltage being used for supplying the high-power amplifier.

6. The system of any of claims 1-5, wherein at least one of the low-power amplifier and high-power amplifier is included in an integrated circuit.

7. The system of claim 6, wherein the high-power loudspeaker comprises a thermally conducting portions and the integrated circuit that includes the high-power amplifier is thermally coupled to the thermally conducting portions of the high-power loudspeaker.

8. The system of any of claims 1-7, wherein the zone computer comprises a digital signal processor and a line interface.

9. The system of claim 8, wherein the zone computer further comprises at least one of an audio source, a low-power regulator and a multiplicity of second analog filters.

10. The system of any of claims 1-9, wherein the low-power active loudspeaker arrangement comprises a tweeter or mid-range loudspeaker, and the high-power active loudspeaker arrangement comprises a mid-range loudspeaker, a woofer, or a subwoofer.

11. The system of any of claims 1-10, further comprising at least one additional low-power active loudspeaker arrangement, wherein the sum of the powers of the low-power active loudspeaker arrangement and the at least one additional low-power active loudspeaker arrangement is below the threshold.

12. The system of any of claims 1-11, further comprising at least one additional high-power active loudspeaker arrangement, the at least one additional high-power active loudspeaker arrangement comprising a high-power loudspeaker and a high-power amplifier, the high-power amplifier being supplied with the high electric power and driving the high-power loudspeaker.

13. An audio reproduction method comprising:
generating audio data and control data to be supplied to a serial bus;
supplying low electric power to the serial bus, the low electric power having a maximum value below a threshold;
transmitting the low electric power and, using serial data communication, the audio data and control data over the serial bus;
supplying high electric power, the high electric power having a maximum value above the threshold;
receiving the audio data, control data, and low electric power over the serial bus and reproducing the received audio data using a low-power loudspeaker and a low-power amplifier, the low-power amplifier being supplied with the low electric power and driving the low-power loudspeaker; and
receiving the audio data and control data over the serial bus and the high electric power over a separate line, and reproducing the received audio data using a high-power loudspeaker and a high-power amplifier, the high-power amplifier being supplied with the high electric power and driving the high-power loudspeaker.

14. The method of claim 13, wherein data and power are transmitted over a two-wire data and power bus as the serial bus.

15. The method of claim 13 or 14, further comprising reproducing the received audio data using at least one additional low-power loudspeaker and at least one additional low-power amplifier, the at least one additional low-power amplifier being supplied with the low electric power and driving the at least one additional low-power loudspeaker, the sum of the powers of the low-power amplifier and the at least one additional low-power active amplifier being below the threshold.
